Europäisches Patentamt

European Patent Office

Office européen des brevets

(19)

(11) Publication number: **0 173 850**
**A1**

(12) **EUROPEAN PATENT APPLICATION**

(21) Application number: **85109371.6**

(22) Date of filing: **25.07.85**

(51) Int. Cl.⁴: **G 01 R 31/28**

(30) Priority: **30.07.84 IT 8494384**

(43) Date of publication of application:
**12.03.86 Bulletin 86/11**

(84) Designated Contracting States:
**CH DE FR GB LI SE**

(71) Applicant: **CIRCUIT LINE S.r.l.**
**Zona Industriale Bassone Via Siderurgia 1**
**I-37139 Verona(IT)**

(72) Inventor: **De Rossi, Ivo**
**Via Carducci 3**
**I-37020 Arbizzano di Negrar (Verona)(IT)**

(74) Representative: **Modiano, Guido et al,**
**MODIANO & ASSOCIATI S.A.S. Via Meravigli, 16**
**I-20123 Milan(IT)**

(54) Apparatus for printing and/or displaying faulty polygonal lines in a printed circuit.

(57) The apparatus comprises a microprocessor (10) and a processing unit (1) combined with input peripheral units (2,3,4) and peripheral output units (5) and (6). The input peripheral units supply the processing unit (1) with all information concerning complete configuration or pattern of a printed circuit being tested, the coordinates of the perforations or holes and those of the ends of one or more faulty polygonal lines. The output unit (5) prints or clearly displays the paths of faulty polygonal lines, as it is connected to the processing unit (1) which processes, through a software (S1), any input data applied to it and supplies the peripheral unit (5) with proper instructions. The peripheral unit (6) provides only the coordinates of those locations on the printed circuit which must be scanned by the peripheral unit (4) which is an analyzer and has only one pair of sensors, the said coordinates being applied to the peripheral unit (5) by the processing unit (1) when controlled by a second software (S2).

./...

FIG1

- 1 -

0173850

"APPARATUS FOR PRINTING AND/OR DISPLAYING FAULTY
POLYGONAL LINES IN A PRINTED CIRCUIT"

As is known, printed circuits produced at present
comprise either a single layer or a plurality of
layers (multi-layer printed circuits). It is necessary
to check that each printed circuit is free of any
faulty due either to a break in one or more paths or
to a short-circuit being established between adjacent
or close circuit paths.

A well known apparatus for testing printed circuits
is the analyzer. An analyzer is equipped with a sensing
system having a multiplicity of pins located at the
crossing of a standard gred, so that for each crossing
there corresponds a hole in any type of printed circuit
being tested. Testing results in a series of geometric
coordinates being generated at the analyzer output
which relate to the ends of any cut off or short-circuited polygonal or broken line.

Accordingly, the operator needs only to follow
all the paths leading to one individual coordinate
and look for a single path or polygonal line having
the other end coordinate supplied by the analyzer.
Undoubtedly, such a search is rather difficult and
keeps the operator busy for a long time.

An object of the present invention is to considerably simplify the testing operation of printed
circuits, including multi-layer printed circuits, by
providing an apparatus capable of supplying the operator with a print or a real dimension visual display
of the faulty polygonal lines in any printed circuit for which electronic testing has given a negative result.

Another object of the present invention is to make it possible to print out or to obtain visual display of any faulty polygonal lines in different colors for the various layers or paths of a printed circuit being tested.

Another object of the present invention is that the said apparatus can "selflearn" or survey the entire configuration of a printed circuit, so as to provide a combination of geometric coordinates which relate exclusively to those locations which must be necessarily checked and tested on an analyzer as to their efficiency; this being obtained by the use of an analyzer which includes a sensing system with a very limited number of sensors which may even be reduced to two units only.

These and other objects are achieved according to the present invention by an apparatus for printing and/or displaying faulty polygonal lines in a single- or multi-layer printed circuit comprising in combination a microprocessor controllable by a first specific software and comprising at least one processing unit designed to receive input data concerning information on the coordinates of the ends of one or more faulty polygonal lines on a printed circuit which has already given negative result on electric testing, an input peripheral unit having a printed circuit analyzer and arranged to provide the said information data; at least one input peripheral unit designed to supply information on the pattern of polygonal lines of the printed circuit as well as information about the position of perforations or holes in said printed circuit, all such information being fed as further input data to the said processing unit; and at least one first output peripheral unit arranged to produce a print and/or display of any faulty polygonal lines in the printed circuit according to instructions received by said processing unit once it has processed all input data in accordance with said software.

According to a preferred embodiment of the invention, the said processing unit, when controlled by a second specific software and with the sole data received from the peripheral unit, can locate just those coordinates of the printed circuit being tested which relate to areas or points of the circuit which must be tested in order to establish whether the printed circuit is in order, the said coordinates being provided by a second output peripheral unit which is arranged to supply such coordinates to the input peripheral unit or analyzer that can thus have a very limited number of sensors and even two sensors only.

The following advantages can be obtained with the apparatus described above. The operator has available not only the coordinates of the polygonal or broken lines affected by failures, but also a print and/or visual display of the path of the faulty polygonal lines. Thus, spotting a fault is a very rapid operation. The coordinates that are provided by the second peripheral unit and relate to those areas or points of the printed circuit which must be tested are extremely reduced in number with respect to the areas or points normally to be scanned by known analyzers. Accordingly, it is also possible to test any printed circuit in a very short time by using an analyzer which could have only two sensors. Such an analyzer, which is per se very economical and functional, is the same analyzer which is designed to supply the microprocessor with the error coordinates.

It will be noted that it is possible to use a standard analyzer with a complete sensing system, that is with a multiplicity of pin sensors, in that case a respective output peripheral unit is   not needed.

Further aspects and advantages of the invention will become apparent from the following detailed description of a preferred embodiment thereof with reference to the accompanying drawings in which:

Figure 1 is a block diagram illustrating in principle the invention;

Figure 2 shows a portion of a printed circuit having various faulty polygonal lines;

Figure 3 shows the print or  video display of a first faulty polygonal line in the printed circuit portion of Figure 2;

Figure 4 shows the print of a second faulty polygonal line in the same printed circuit portion shown in Figure 2; and

Figure 5 shows a combination of star connected polygonal lines on a printed circuit which differs from that shown in Figure 2.

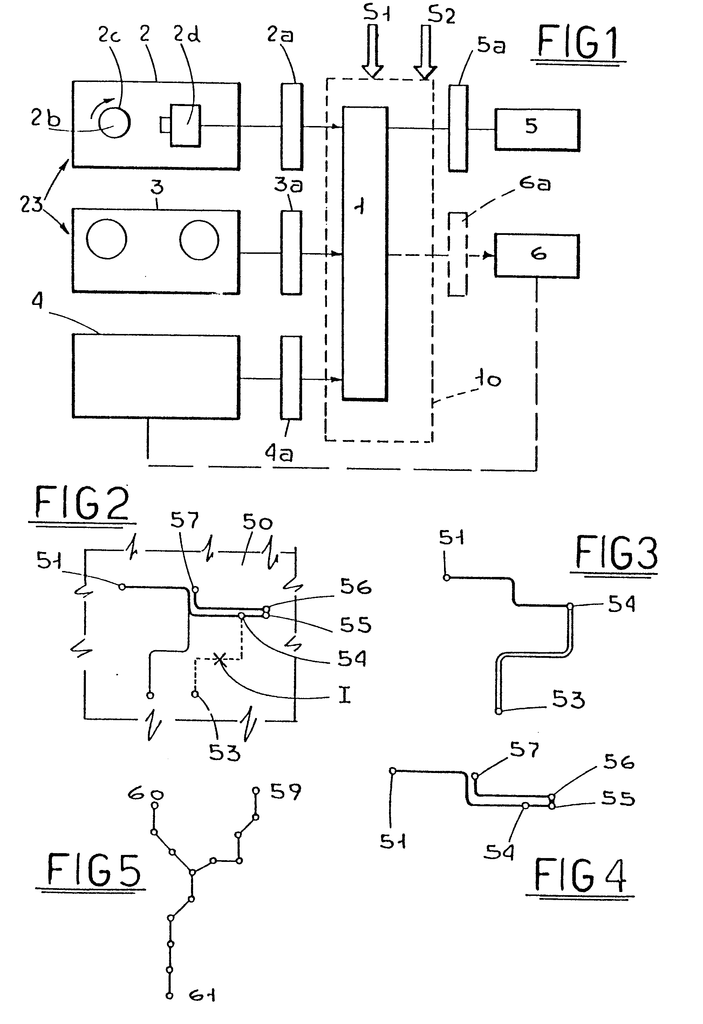

With reference to the above figures and specifically to Figure 1, the apparatus according to the present invention comprises a microprocessor 10, only its processing unit 1 being shown for clarity, at least one input peripheral unit 23, a further input peripheral unit 4, and two output peripheral units 5 and 6.

The input peripheral unit 23 substantially comprises an optical reader 2 arranged to detect the configuration of a printed circuit 50 being tested and a perforated tape or magnetic support reader 3 which provides the geometric coordinates of the perforations formed in the printed circuit being tested. Between the peripheral units 2, 3, 4, 5 and 6 and the microprocessor 10 or processing unit 1, respective suitable interface 2a, 3a, 4a, 5a and 6a, are located. In particular, the optical reader 2 comprises a lighted or luminous roll 2b which can be rotated by a small step motor not shown, and carries one or more films 2c of the printed circuit being tested whose pattern is read by a television camera 2d of the line scanning type which supplies, via the interface 2a, binary information on each read and scanned line to the processing unit 1. Thus, the optical reader 2 reads the pattern of any polygonal line in the printed circuit being tested and supplies respective information to the microprocessor 10 which processes it, in accordance with a specific software S1, as explained hereinafter.

The reader 3 reads the information on the printed circuit stored in a standard punched tape or in any suitable magnetic support and provides the microprocessor 10 with all the geometric coordinates of the perforations or holes in the printed circuit being tested. The input peripheral unit 4 is an analyzer which, if compatible with the microprocessor 10, supplies the latter with the geometric coordinates relating to the ends of one or more faulty polygonal lines located on the printed circuit being tested. Of course it is assumed that the printed circuit being tested has already given negative results on electric testing.

The output peripheral unit 5 receives, from the microprocessor 10 or processing unit 1, all the instructions to be enabled to print out on paper or visually display those polygonal lines which are affected by failure, so that the operator is immediately in the position of looking for and viewing the failure such as a break in a polygonal line, or short-circuiting between two adajcent polygonal lines. As already explained above, all this is possible owing to the processing unit 1 being operated in accordance with the cited software S1.

The latter function is further explained with reference to Figures 2, 3 and 4. It should be noted that the polygonal lines may also lie on different planes, e.g. as shown in Figure 2, where the polygonal line comprising holes 51,54 and 53 includes a first path, i.e. that delimited by the holes 51 and 54 on the first layer, and a second path delimited by the hole 54 underlying the upper hole 54 and the hole 53 both formed in an underlying layer. Let us assume that in the polygonal line leading to the holes 51 and 53 there is a break 1, as shown in Figure 2, while a short circuit is established between the holes 56 and 55.

In such conditions, the peripheral unit 5 will print out the very polygonal line 51-53 which is affected by the break 1 and shows in particular the polygonal line 51-54 in one color and the polygonal line 54-53 in a different color to advantageously differentiate the two different layers on which the two sections or paths lie.

In so far as spotting of the short circuit is concerned, the peripheral unit 5 can print the polygonal line 51-57, since the two holes 55 and 56 are erroneously shortcircuited.

It should be clear that color differentiation among faulty polygonal lines can also be obtained between lines affected by different failures rather than between polygonal lines laying on different planes. Through color differentiation the operator will be able to spot almost immediately possible line breaks or shortcircuits in the polygonal lines thus printed or otherwise displayed. Through a second suitable software S2, the microprocessor 10, or processing unit 1, can learn the entire pattern of the printed circuit from the input peripheral units 2 and 3 and process such input-data so as to locate only the geometric coordinates relating to points in the printed circuit being tested that need to be checked to determine the efficiency of the circuit.

0173850

Such coordinates are then supplied to the output peripheral unit 6 which can in turn supply such coordinates as controls to the analyzer 4. The latter by being exempted from heavy testing, can have a quite limited number of sensors, and even two sensors only.

To better explain this second function, reference should be made to Figure 5. If the polygonal lines are star connected, as shown in the drawing, it will be quite sufficient for the analyzer to check the continuity of the polygonal lines shown by merely investigating the holes 59-60 and 59-61 or 60-61 and neglecting all the remaining holes. In other words, with only two measurements it is possible to determine with certainty whether the polygonal lines shown in Figure 5 are faulty or not. Thus, since the task of the analyzer 4 is reduced, the analyzer itself can be produced in a simplified form while being highly efficient.

## CLAIMS

1. An apparatus for printing and/or displaying faulty polygonal lines in a single- or multi-layer printed circuit, characterized in that it comprises in combination a microprocessor (10) controllable by a first specific software (S1), and comprising at least one processing unit (1) designed to receive input data concerning information on the coordinates of the ends of one or more faulty polygonal lines on a printed circuit (50) which has already given negative result on electric testing; an input peripheral unit (4) having a printed circuit analyzer  and arranged to provide the said information  data; at least one input peripheral unit (23) designed to supply information on the pattern of polygonal lines of the printed circuit (50) as well as information about the positions of perforations or holes in said printed circuit (50), all such information being fed as further input data to the said processing unit (1); and at least one first output peripheral unit (5), arranged to produce a print and/or display of any faulty polygonal lines in the printed circuit (50) according to instructions received by said processing unit (1) once it has processed all input data in accordance with said software (S1).

2. An apparatus according to claim 1, further comprising a second peripheral unit (6) arranged to supply to the said analyzer (4) the coordinates of printed-circuit points to be checked as selected by the or each processing unit (1) when operating in accordance with a second specific software (S2) on the data supplied to it by the or each input peripheral unit (23).

3. An apparatus according to claim 1, characterized in that the or each input unit (23) comprises an optical reader (2) of the printed circuit pattern and a reader (3) of a punched tape or magnetic support storing in it the geometric coordinates of the perforations or holes in the printed circuit (50) being tested.

4. An apparatus according to claim 3, characterized in that the said optical reader (2) comprises a lighted rotatable roll (2b) supporting one or more films (2c) of the printed circuit, a line scanning television camera (2d) arranged to read the pattern of the printed circuit polygonal lines and to supply the processing unit (1) with binary information on each scanned line, and an interface (2a) unit disposed between the said television camera and the said processing unit.

5. An apparatus according to claim 1, characterized in that the processing unit (1) is arranged to control the or each said first output peripheral unit (5) to print or display faulty polygonal lines in colors which differ from each other layer by layer or path by path.

6. An apparatus for printing or displaying faulty polygonal lines in a single- or multi-layer printed circuit substantially as described above and illustrated in the accompanying drawings.

0173850

FIG1

FIG2

FIG3

FIG5

FIG4

**European Patent Office**

**EUROPEAN SEARCH REPORT**

**0173850**
Application number

EP 85 10 9371

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X | IBM TECHNICAL DISCLOSURE BULLETIN, vol. 14, no. 12, May 1972, pages 3621-3622; S.H. CAMPBELL et al.: "Noncontact test system" <br> * pages 3621-3622 * | 1,3,6 | G 01 R 31/28 |
| X | PROCEEDINGS OF THE IEEE, vol. 69, no. 12, December 1981, pages 1524-1538, New York, US; R.P. KRUGER et al.: "A technical and economic assessment of computer vision for industrial inspection and robotic assembly" <br> * page 1526, right-hand column "Automated visual inspection systems" - page 1529 "Industrial part identification systems"; page 1531, figure 11 * | 1,3,6 | |
| Y | MICROELECTRONICS & RELIABILITY, vol. 20, no. 5, 1980, pages 717-735, Oxford, GB; M. NAGASE "A device analysis system based on Laser scanning techniques" <br> * page 718; figure 1, page 721; figure 2 * | 5 | **TECHNICAL FIELDS SEARCHED (Int. Cl.4)** <br><br> G 01 R 31/28 |
| A | idem | 4 | |

-/-

The present search report has been drawn up for all claims

| Place of search | Date of completion of the search | Examiner |
|---|---|---|
| BERLIN | 23-10-1985 | LEMMERICH J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82

| DOCUMENTS CONSIDERED TO BE RELEVANT | | | Page 2 |
|---|---|---|---|
| Category | Citation of document with indication where appropriate, of relevant passages | Relevant to claim | CLASSIFICATION OF THE APPLICATION (Int Cl 4) |
| Y | SOLID STATE TECHNOLOGY, vol. 23, no. 10, October 1980, pages 123-129, New York, US; L. ARLAN et al.: "Computer controlled imaging system for automatic hybrid inspection" * page 123; summary * | 5 | |
| | ----- | | |
| | | | TECHNICAL FIELDS SEARCHED (Int Cl 4) |

The present search report has been drawn up for all claims

| Place of search | Date of completion of the search | Examiner |
|---|---|---|
| BERLIN | 23-10-1985 | LEMMERICH J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82